(19) Europäisches Patentamt
European Patent Office
Office européen des brevets

(11) **EP 2 883 253 B1**

(12) **EUROPÄISCHE PATENTSCHRIFT**

(45) Veröffentlichungstag und Bekanntmachung des Hinweises auf die Patenterteilung:
**24.05.2017 Patentblatt 2017/21**

(21) Anmeldenummer: **13745819.6**

(22) Anmeldetag: **31.07.2013**

(51) Int Cl.:
***H01L 41/27*** *(2013.01)*

(86) Internationale Anmeldenummer:
**PCT/EP2013/066117**

(87) Internationale Veröffentlichungsnummer:
**WO 2014/023634 (13.02.2014 Gazette 2014/07)**

(54) **VERFAHREN ZUM BEFÜLLEN VON MINDESTENS EINER KAVITÄT EINES VIELSCHICHTBAUELEMENTS MIT EINEM FÜLLMATERIAL**

METHOD FOR FILLING AT LEAST ONE CAVITY OF A MULTI-LAYER COMPONENT WITH A FILLING MATERIAL

PROCÉDÉ DE REMPLISSAGE D'AU MOINS UNE CAVITÉ D'UN ÉLÉMENT MULTICOUCHE AVEC UN MATÉRIAU DE REMPLISSAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.08.2012 DE 102012107341**

(43) Veröffentlichungstag der Anmeldung:
**17.06.2015 Patentblatt 2015/25**

(73) Patentinhaber: **Epcos AG**
**81669 München (DE)**

(72) Erfinder:
• **SOMITSCH, Dieter**
**A-8522 Groß St. Florian (AT)**
• **GALLER, Martin**
**A-8401 Kalsdorf (AT)**
• **RAJAPURKAR, Aditya**
**A-8020 Graz (AT)**

(74) Vertreter: **Epping - Hermann - Fischer**
**Patentanwaltsgesellschaft mbH**
**Schloßschmidstraße 5**
**80639 München (DE)**

(56) Entgegenhaltungen:
**JP-A- H0 473 977     JP-A- 2005 055 489**
**US-A1- 2003 223 155**

**Beschreibung**

Es wird ein Verfahren zum Befüllen von mindestens einer Kavität eines Vielschichtbauelements mit Füllmaterial sowie ein Vielschichtbauelement angegeben. Beispielsweise ist das Vielschichtbauelement ein Piezoaktor, der zum Betätigen eines Einspritzventils in einem Kraftfahrzeug eingesetzt werden kann. Alternativ kann das Vielschichtbauelement beispielsweise ein Vielschichtkondensator sein.

In den Druckschriften DE 10 2006 001 656 A1, DE 44 10 504 B4 und DE 10 2007 004 813 A1 sind elektrochemische Ätzverfahren zur Ausbildung von Isolationszonen in Vielschichtbauelementen beschrieben. Ferner zeigt US 2003/223155 A1 ein Vielschichtbauelement, bei dem Kavitäten mit einem Füllmaterial gefüllt sind. JP 2005-055489 A zeigt ein Bauelement, das Ausnehmungen aufweist, die mit einem Elastomer gefüllt sind. JP H04 73977 A zeigt ein die Herstellung eines Vielschichtbauelements, wobei das Vielschichtbauelement in einer Kammer angeordnet wird, in der ein Vakuum erzeugt wird, und wobei anschließend das Vielschichtbauelement in ein Bad eines Mittels eingetaucht wird, welches in spiralförmige Öffnungen des Vielschichtbauelements eindringt.

Es ist eine zu lösende Aufgabe, ein verbessertes Verfahren zum Befüllen einer Kavität eines Vielschichtbauelements mit Füllmaterial anzugeben.

Es wird ein Verfahren gemäß dem unabhängigen Verfahrensanspruchs 1 zum Befüllen von mindestens einer Kavität eines Vielschichtbauelements mit Füllmaterial angegeben. Das Verfahren umfasst in einem ersten Schritt die Bereitstellung eines Grundkörpers des Vielschichtbauelements, wobei der Grundkörper mindestens eine Kavität aufweist. In einem nachfolgenden Schritt erfolgt das Platzieren des Grundkörpers in einer Kammer. Anschließend wird ein erster Druck in der Kammer erzeugt, wobei der erste Druck ein Unterdruck ist. Anschließend wird Füllmaterial am Grundkörper angeordnet.

Vorzugsweise wird der Grundkörper zunächst derart in der Kammer platziert, dass er nicht mit bereits in der Kammer vorhandenem Füllmaterial in Kontakt kommt.

Vorzugsweise wird Luft, insbesondere ein Großteil der Luft, aus der mindestens einen Kavität entfernt, so dass das Risiko einer späteren Blasenbildung im Isoliermaterial verringert wird.

Vorzugsweise soll das Isoliermaterial möglichst wenige Blasen aufweisen. Dadurch kann das Risiko eines elektrischen Durchschlags, beispielsweise zwischen einer internen Elektrodenschicht des Grundkörpers und einer auf dem Grundkörper angeordneten Außenkontaktierung, verringert werden.

Der Grundkörper kann einen Stapel aus dielektrischen Schichten und internen Elektrodenschichten aufweisen. Beispielsweise sind dielektrische Schichten und interne Elektrodenschichten entlang einer Stapelrichtung gestapelt. Die Stapelrichtung entspricht vorzugsweise der Längsrichtung des Grundkörpers. Vorzugsweise sind dielektrische Schichten und interne Elektrodenschichten alternierend übereinander gestapelt.

In einer Ausführungsform weist der Grundkörper erste und zweite interne Elektrodenschichten auf, welche in Stapelrichtung gesehen alternierend aufeinander folgen. Die ersten internen Elektrodenschichten erstrecken sich bis zu einer ersten Außenseite, und die zweiten internen Elektrodenschichten erstrecken sich bis zu einer zweiten Außenseite. Die erste und die zweite Außenseite liegen sich beispielsweise gegenüber.

Die dielektrischen Schichten können ein piezoelektrisches Material, zum Beispiel ein keramisches Material, aufweisen. Zur Herstellung des Grundkörpers können Grünfolien verwendet werden, auf die zur Bildung von internen Elektrodenschichten beispielsweise eine Metallpaste aufgebracht wird. Beispielsweise wird die Metallpaste in einem Siebdruckverfahren aufgebracht. Die Metallpaste kann Kupfer enthalten. Beispielsweise werden daraus interne Elektrodenschichten gebildet, die Kupfer als Hauptbestandteil enthalten. Alternativ kann die Metallpaste Silber-Palladium enthalten, wobei daraus interne Elektrodenschichten gebildet werden können, die Silber-Palladium als Hauptbestandteil enthalten. Nach dem Aufbringen der Metallpaste werden die Folien vorzugsweise gestapelt, verpresst und gemeinsam gesintert, sodass ein monolithischer Sinterkörper entsteht. Vorzugsweise wird der Grundkörper des Bauelements durch einen monolithischen Sinterkörper gebildet, beispielsweise durch einen wie vorhergehend beschrieben hergestellten Sinterkörper.

Die mindestens eine Kavität des Grundkörpers kann beispielsweise als Graben ausgebildet sein. Die Kavität, insbesondere der Graben, kann in einer Ebene mit jeweils einer internen Elektrodenschicht angeordnet sein. Insbesondere kann die Kavität zwischen einer internen Elektrodenschicht und einer Außenseite des Grundkörpers angeordnet sein. Vorzugsweise reicht die Kavität, insbesondere der Graben bis zu einer Außenseite des Grundkörpers. Dadurch sind die Kavitäten zumindest teilweise von der Außenseite aus zugänglich. Insbesondere können die Kavitäten in einem Bereich von der Außenseite aus zugänglich sein, der nicht von einer Außenkontaktierung überdeckt ist.

Der Grundkörper weist vorzugsweise eine Vielzahl von Kavitäten, insbesondere Gräben auf. Im Fall von ersten und zweiten internen Elektrodenschichten, die abwechselnd bis zu einer ersten und zweiten Außenseite reichen ist beispielsweise eine Kavität zwischen jeder ersten internen Elektrodenschicht und der ersten Außenseite des Grundkörpers angeordnet. Auf der gegenüberliegenden zweiten Außenseite des Grundkörpers kann eine Kavität zwischen jeder zweiten internen Elektrodenschicht und der zweiten Außenseite des Grundkörpers angeordnet sein. Dadurch können die ersten und zweiten internen Elektrodenschichten abwechselnd von einer ersten und einer zweiten Außenseite des Grundkörpers beabstandet sein.

Die Kavitäten werden beispielsweise durch ein Ätzverfahren hergestellt. Beispielsweise kann der Grundkörper zum Ätzen der Kavitäten in einem Ätzmedium angeordnet werden, während mittels Elektroden eine Spannung zwischen die internen Elektrodenschichten angelegt wird. Durch das Anlegen einer Spannung kann ein Teil der Elektrode weggeätzt werden, so dass eine Kavität zwischen der internen Elektrodenschicht und einer Außenseite des Grundkörpers entsteht.

Eine Kavität weist beispielsweise eine Breite zwischen 1 $\mu$m und 5 $\mu$m auf. Die Breite der Kavität entspricht vorzugsweise einer Ausdehnung der Kavität entlang der Stapelrichtung des Grundkörpers. Aufgrund dieser geringen Breite sind die Kavitäten schwer befüllbar. Insbesondere Materialien mit hohen Viskositäten können nur schwer in die Kavitäten gefüllt werden. Des Weiteren kann die Kavität eine Tiefe zwischen 80 $\mu$m und 120 $\mu$m aufweisen. Zudem kann die Kavität eine Länge zwischen 3 mm und 4 mm aufweisen. Die Länge der Kavität entspricht vorzugsweise einer Ausdehnung der Kavität senkrecht zur Stapelrichtung des Grundkörpers.

Da die Kavitäten Abmessungen im Mikrometer-Bereich aufweisen, spricht man auch von mikrostrukturierten Hohlräumen.

Das Füllmaterial ist beispielsweise ein Isoliermaterial. Beispielsweise weist das Isoliermaterial eine Viskosität zwischen 200 mPas und 2000 mPas auf. Gemäß einer bevorzugten Ausführungsform weist das Isoliermaterial eine Viskosität zwischen 300 mPas und 500 mPas auf. Das Isoliermaterial ist beispielsweise ein Silikon-Elastomer oder ein Polyimid oder enthält ein Silikon-Elastomer oder einen Polyimidbestandteil. Beispielsweise ist das Isoliermaterial eine Vergussmasse. Das Isoliermaterial weist vorzugsweise ein geringes Schwundverhalten beim Aushärten auf. Zudem weist das Isoliermaterial vorzugsweise einen geringen Dampfdruck auf, so dass das Isoliermaterial beim Erzeugen eines Unterdrucks nicht zu verdampfen beginnt. Zudem sollte das Isoliermaterial keine Füllstoffe enthalten, welche die Gräben verstopfen können. Des Weiteren sollte das Isoliermaterial keine oder eine möglichst geringe Fließgrenze aufweisen. Die Fließgrenze beschreibt die Kraft, welche aufgebracht werden muss, um einen Stoff bleibend zu verformen.

Durch das Befüllen der Kavitäten mit dem Isoliermaterialmaterial können Isolationszonen gebildet werden, welche eine interne Elektrodenschicht besonders zuverlässig von einer Außenkontaktierung isolieren können.

Die Kavitäten können mit Isoliermaterial gefüllt werden, um die elektrische Durchschlagfestigkeit zu erhöhen, insbesondere um beim Anlegen einer Spannung zwischen die internen Elektrodenschichten einen elektrischen Durchschlag zwischen einer internen Elektrodenschicht und einer Außenkontaktierung zu vermeiden.

Gemäß einer Ausführungsform ist auf dem Grundköper bereits vor dem Platzieren des Grundköpers in der Kammer mindestens eine Außenkontaktierung angeordnet. Beispielsweise überdeckt die Außenkontaktierung die mindestens eine Kavität des Grundkörpers zumindest teilweise. Beispielsweise weist die Außenkontaktierung Silber-Palladium oder Kupfer oder Silber auf oder besteht aus Silber-Palladium oder Kupfer oder Silber. Die Außenkontaktierung ist beispielsweise streifenförmig auf einer Außenseite aufgebracht. Beispielsweise ist die Außenkontaktierung mittels Siebdruckens aufgebracht. Insbesondere kann die Außenkontaktierung eingebrannt sein. Vorzugsweise ist jeweils eine Außenkontaktierung an zwei gegenüberliegenden Außenseiten des Grundkörpers angeordnet. Die Außenkontaktierung kann die mindestens eine Kavität auf einer Außenseite des Grundkörpers teilweise verdecken. Vorzugsweise bedeckt die Außenkontaktierung die mindestens eine Kavität des Grundkörpers derart, dass die Kavität immer noch von außen zugänglich ist, insbesondere über die Außenseite des Grundkörpers zugänglich ist.

Das Verfahren ist insbesondere geeignet, um eine Kavität auch unterhalb einer aufgebrachten Außenkontaktierung mit Isoliermaterial zu füllen. Dies hat den Vorteil, dass auch Isoliermaterialien verwendet werden können, welche beim Einbrennen der Außenkontaktierung beschädigt werden können.

Gemäß einem alternativen Verfahren können die Außenelektroden auch nach dem Befüllen der Kavitäten mit Isoliermaterial aufgebracht werden.

An der Außenkontaktierung ist vorzugsweise ein Kontaktelement angeordnet. Das Kontaktelement dient vorzugsweise zur Weiterkontaktierung des Vielschichtbauelements. Das Kontaktelement kann beispielsweise einen Kontaktdraht aufweisen. Zusätzlich oder alternativ kann das Kontaktelement ein Verstärkungselement aufweisen, welches an der Außenkontaktierung angeordnet sein kann, beispielsweise ein Siebgewebe oder eine Drahtharfe. Das Kontaktelement ist beispielsweise mit der Außenkontaktierung verlötet. Der Kontaktdraht kann beispielsweise an der Außenkontaktierung oder an dem Verstärkungselement angeordnet sein.

Die Außenkontaktierung kann beispielsweise einen Spalt aufweisen, welcher sich in Längsrichtung der Außenkontaktierung erstreckt. Durch den Spalt ergibt sich eine zusätzliche Öffnung auf der Außenseite des Grundkörpers, durch die das Isoliermaterial unter die Außenkontaktierung in die Kavität fließen kann.

Zum Befüllen der mindestens einen Kavität mit Isoliermaterial kann beispielsweise bereits während dem Platzieren des Grundkörpers in der Kammer ein Isoliermaterial in der Kammer angeordnet sein. Alternativ kann das Isoliermaterial erst in einem späteren Verfahrensschritt in die Kammer eingebracht werden.

Das Platzieren des Grundkörpers in der Kammer kann mit Hilfe einer Einspannvorrichtung erfolgen. Die Einspannvorrichtung ist beispielsweise eine Klemme. Der Grundkörper kann derart in der Einspannvorrichtung befestigt werden, dass eine Oberseite und eine Unterseite des Grundkörpers bedeckt sind. Zusätzlich können auch Bereiche abgedeckt werden, welche zur Weiterkontaktierung des Vielschichtbauelements vorgesehen sind. Beispielsweise kann ein zur Weiterkontaktierung an der Außenkontaktierung angebrachtes Siebgeflecht abgedeckt werden. Dadurch wird gewährleistet, dass eine zuverlässige Kontaktierung des Vielschichtbauelements erfolgen kann. Insbesondere wird die elektrische Kontaktierung nicht durch eventuell an der Weiterkontaktierung haftendes Isoliermaterial beeinflusst.

Gemäß einer Ausführungsform kann der Grundkörper in einer Hülse angeordnet sein. Der Grundkörper kann zusammen mit der Hülse in der Einspannvorrichtung befestigt und in der Kammer platziert werden. Die Hülse kann beispielsweise nach dem Befüllen der mindestens einen Kavität mit Isoliermaterial am Bauelement verbleiben. Die Hülse kann beispielsweise beim späteren Einsatz des Vielschichtbauelements dem Schutz des Vielschichtbauelements, beispielsweise vor Schmutz oder mechanischen Einflüssen dienen.

Gemäß einer Ausführungsform des Verfahrens wird nach dem Platzieren des Grundkörpers in der Kammer und dem Erzeugen des ersten Drucks, insbesondere eines Unterdrucks, der Grundkörper in das bereits in der Kammer vorhandene Isoliermaterial eingetaucht. Alternativ wird die Kammer vollständig mit Isoliermaterial gefüllt. Alternativ wird nur eine Hülse, in der der Grundkörper angeordnet sein kann, mit Isoliermaterial gefüllt, beispielsweise mittels einer Sonde. Das in die Hülse gefüllte Isoliermaterial kann auch nach dem Befüllungsprozess in der Hülse verbleiben und ausgehärtet werden. Insbesondere kann das in der Hülse befindliche Isoliermaterial den Grundkörper nach dem Aushärten umgeben und als Passivierungsmaterial dienen.

Gemäß einer bevorzugten Ausführungsform kommt der Grundkörper derart mit Isoliermaterial in Kontakt, dass zumindest die Bereiche des Grundkörpers, in welchen die Gräben von außen zugänglich sind, mit Isoliermaterial bedeckt sind.

In einem darauffolgenden Verfahrensschritt wird der Druck in der Kammer auf einen zweiten Druck erhöht. Beispielsweise wird der Druck durch ein Belüften der Kammer erhöht. Bekannterweise wird der Druck in der Kammer auf den normalen Luftdruck erhöht. Die Kammer kann beispielsweise über ein Ventil be- und entlüftet werden. Nach dem Belüften der Kammer kann der Druck noch weiter erhöht werden. Erfindungsgemäß wird ein Überdruck angelegt. Insbesondere wird das Isoliermaterial mit dem zweiten Druck beaufschlagt.

Alternativ kann der Druck in der Kammer durch eine Deformation zumindest einer Außenwand der Kammer erzeugt werden. Dabei ist die Kammer vorzugsweise vollständig mit Isoliermaterial gefüllt. Die Kammer kann durch Krafteintragung, zum Beispiel mittels einer Presse, deformiert werden. Eine derartige Deformation bewirkt eine Verringerung des Innenraum-Volumens. Aufgrund einer weitgehenden Inkompressibilität des Isoliermaterials wird dadurch der Druck des Isoliermaterials erhöht.

Durch eine derartige Erhöhung des Drucks kann das Isoliermaterial in die mindestens eine Kavität des Grundkörpers gedrückt werden.

Gemäß einer Ausführungsform des Verfahrens kann eine Blende über der mindestens einen Kavität des Grundkörpers, insbesondere einem von außen zugänglichen Teil der Kavität, angeordnet werden.

Vorzugsweise kann in dem Bereich, in welchem die Blende angeordnet ist, kein Isoliermaterial direkt in die Kavität einfließen. Das Isoliermaterial kann vorzugsweise nur über einen Bereich der Kavität einströmen, welcher nicht von der Blende oder der Außenkontaktierung bedeckt ist.

Die Blende wird vorzugsweise derart angeordnet, dass sie zusammen mit der Außenkontaktierung einen durchgehenden Bereich auf der Außenseite des Grundkörpers abdeckt. Insbesondere deckt die Blende einen Bereich der mindestens einen Kavität ab, so dass diese in diesem Bereich nicht mehr direkt von außen zugänglich ist. Vorzugsweise deckt die Blende einen Bereich auf der Außenseite des Grundkörpers ab, der neben der Außenkontaktierung liegt, und dessen Breite größer ist als die Breite eines durch die Außenkontaktierung durchgängig abgedeckten Bereichs. Die Breite des von der Blende und der Außenkontaktierung abgedeckten Bereichs entspricht vorzugsweise einer Ausdehnung des Bereichs senkrecht zur Stapelrichtung des Grundkörpers. Ein durchgängig abgedeckter Bereich ist beispielsweise ein Bereich auf der Außenseite des Grundkörpers, in dem die mindestens eine Kavität nicht von außen zugänglich ist. Insbesondere befindet sich in dem abgedeckten Bereich keine Öffnung, durch die Material in die mindestens eine Kavität einströmen kann.

Das Isoliermaterial kann beispielsweise durch mindestens zwei Eintrittsöffnungen in einen Bereich unterhalb der Außenkontaktierung einströmen. Die Eintrittsöffnungen können beispielsweise an die Enden des durchgängig abgedeckten Bereichs angrenzen. Vorzugsweise kann das Einströmen des Isoliermaterials in den Bereich unter der Außenkontaktierung und unter die Blende symmetrisch erfolgen. Das heißt, das Isoliermaterial fließt durch die Eintrittsöffnungen von Seiten der Außenkontaktierung und von Seiten der Blende mit einer gleichen Geschwindigkeit in die Gräben, so dass sich die Materialströme des Isoliermaterials in der Mitte des abgedeckten Bereichs treffen können. Dadurch dass die Breite der Blende in einem Bereich neben der Außenkontaktierung größer ist als die Breite der Außenkontaktierung, liegt die Mitte des abgedeckten Bereichs nicht unterhalb der Außenkontaktierung.

In den Kavitäten befindliche Luft wird beispielsweise beim Einströmen des Isoliermaterials in eine Kavität vor den Materialströmen hergeschoben. Dadurch treten Lufteinschlüsse, insbesondere Blasen, besonders häufig in einem Bereich auf, in dem die Materialströme des Isoliermaterials aufeinander treffen. Durch die wie vorhergehend beschriebene Anordnung der Blende kann somit vermieden werden, dass Blasen in einem Bereich unterhalb der Außenkontaktierung auftreten. Dadurch wird das Risiko eines elektrischen Durchschlags zwischen einer internen Elektrodenschicht und der Außenkontaktierung reduziert.

Vorzugsweise wird durch das Anlegen des Unterdrucks vor dem Befüllen der Kavitäten mit Isoliermaterial Luft, insbesondere ein Großteil der Luft, aus den Kavitäten entfernt, so dass beim Zusammentreffen der Materialströme des Isoliermaterials in den Kavitäten keine Luftblasen entstehen können. Für den Fall, dass dennoch Luftblasen entstehen, kann wie vorhergehend beschrieben durch die Blende der Ort des Zusammentreffens der Materialströme des Isoliermaterials derart verlagert werden, dass eventuell entstehende Luftblasen vorzugsweise nicht in einem Bereich unterhalb der Außenkontaktierung auftreten. Die Luftblasen befinden sich dann vorzugsweise in einem unkritischen Bereich, in dem kein elektrischer Durchschlag zwischen der Außenkontaktierung und einer internen Elektrodenschicht erfolgen kann.

Zusätzlich kann die Blende auch über der Außenkontaktierung angeordnet sein, so dass durch die Blende zumindest ein Teil der Außenkontaktierung bedeckt ist. Zusätzlich kann durch die Blende zumindest ein Teil des Kontaktelements, insbesondere ein Teil des Verstärkungselements abgedeckt sein. Dadurch kann sich zumindest in dem abgedeckten Bereich nahezu kein Isoliermaterial auf der Außenkontaktierung oder auf dem Kontaktelement absetzen. Somit kann eine zuverlässige Kontaktierung des Vielschichtbauelements erfolgen.

In einem darauffolgenden Schritt kann das somit entstandene Vielschichtbauelement aus der Kammer entfernt werden. Falls in der Kammer ein Überdruck herrscht, findet vor dem Entfernen des Vielschichtbauelements aus der Kammer vorzugsweise ein Druckausgleich statt.

Anschließend kann das Isoliermaterial ausgehärtet werden.

Der zu einem zuverlässigen Befüllen der Gräben nötige Differenzdruck zwischen dem ersten und dem zweiten Druck kann gemäß dem Stokes'schen Gesetz und dem Hagen-Poiseuille Gesetz berechnet werden.

Insbesondere kann der Druckabfall in einer geraden Rohrleitung bei laminarer Rohrströmung berechnet werden. Die Rohrleitung kann dabei als Ersatzmodell für eine unter der Außenkontaktierung liegenden Kavität des Grundkörpers dienen.

Als Modell wird dafür die Durchströmung eines Rohres mit kleinen Abmessungen herangezogen. Dieses Modell entspricht einem Standardbeispiel in der Strömungsmechanik. Dabei wird davon ausgegangen, dass die Strömungsverhältnisse in einem Spalt günstiger sind als bei dem herangezogenen Rohrmodell. Des Weitern liegen beim Auffüllen eines Rohrs oder eines Spalts günstigere Bedingungen vor als beim Durchströmen eines entsprechenden Rohrs oder Spalts. Damit ist der reale Fall günstiger als das beschriebene Berechnungsmodell. In der Realität ist die benötigte Druckdifferenz somit geringer als die im Folgenden berechnete.

In dem Berechnungsmodell werden folgende Parameter festgelegt:

Ein Rohrradius $r_0$ von 1 $\mu$m;
eine Rohrlänge l von 1 mm;
eine dynamische Viskosität $\eta$ von 400 mPas;
eine mittlere Strömungsgeschwindigkeit $V_{mit}$ von 10 $\mu$m/s.

Diese Parameter sollen eine vergleichbare Situation zu einem Grundkörper mit einer Kavität der Breite 2 $\mu$m und einer Breite einer Außenkontaktierung von 2 mm abbilden. Dies ist möglich, da der Bereich unter der Außenkontaktierung annäherungsweise als Rohr betrachtet werden kann.

Aus der Formel

$$V_{mit} = (p_2 - p_1) * r_0^2 / (8\eta l)$$

folgt für den erforderlichen Differenzdruck:

$$(p_2 - p_1) = V_{mit}(8\eta l)/r_0^2 = 10^{-5} * (8 * 0,4 * 10^{-3})/(10^{-6})^2 = 3,2 * 10^4 \ N/m^2$$

$$= 320 \ mbar$$

wobei $p_1$ dem ersten Druck und $p_2$ dem zweiten Druck entspricht.

Des Weiteren wird ein Vielschichtbauelement angegeben. Das Vielschichtbauelement weist einen Grundkörper mit mindestens einer Kavität auf, wobei die Kavität mit einem Füllmaterial gefüllt ist, welches eine Viskosität zwischen 200 mPas und 2000 mPas aufweist. Vorzugsweise weist das Füllmaterial eine Viskosität zwischen 300 mPas und 500 mPas auf. Vorzugsweise erstreckt sich die Kavität bis zu einer Außenseite des Grundkörpers.

Das Füllmaterial ist beispielsweise ein wie oben beschriebenes Isoliermaterial.

Die Kavität des Vielschichtbauelements weist vorzugsweise eine Breite zwischen 1 $\mu$m und 5 $\mu$m auf. Des Weiteren kann die Kavität eine Tiefe zwischen 80 $\mu$m und 120 $\mu$m aufweisen. Zudem kann die Kavität eine Länge zwischen 3 mm und 4 mm aufweisen.

Vorzugsweise ist das Vielschichtbauelement durch ein wie oben beschriebenes Verfahren hergestellt und kann alle funktionellen und strukturellen Eigenschaften des bezüglich des Verfahrens beschriebenen Vielschichtbauelements aufweisen.

Im Folgenden werden das Verfahren zur Herstellung eines Vielschichtbauelements und das Vielschichtbauelement anhand von schematischen und nicht maßstabsgetreuen Figuren erläutert.

Es zeigen:

Figur 1          einen Längsschnitt eines Vielschichtbauelements,

Figur 2          einen Querschnitt des Vielschichtbauelements aus Figur 1,

Figuren 3A und 3B     einen Verfahrensablauf zum Befüllen von Kavitäten eines Vielschichtbauelements mit Füllmaterial,

Figuren 4A bis 4C     einen alternativen Verfahrensablauf zum Befüllen von Kavitäten eines Vielschichtbauelements mit Füllmaterial,

Figuren 5A und 5B     einen weiteren alternativen Verfahrensablauf zum Befüllen von Kavitäten eines Vielschichtbauelements mit Füllmaterial,

Figur 6          einen Querschnitt eines weiteren Vielschichtbauelements,

Figur 7          einen Ausschnitt aus dem Querschnitt eines Vielschichtbauelements gemäß Figur 6 mit einer auf dem Vielschichtbauelement angeordneten Blende.

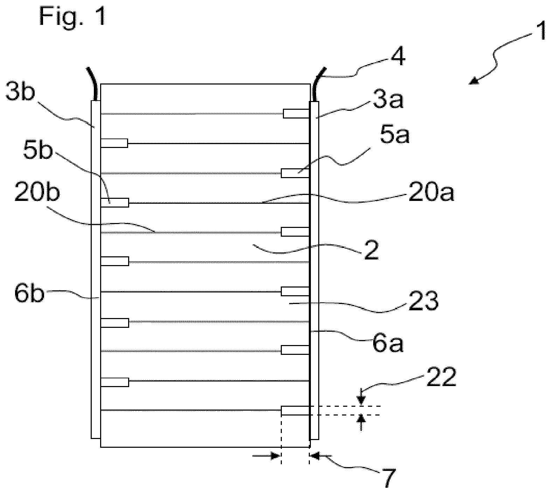

Figur 1 zeigt einen Querschnitt eines Vielschichtbauelements 1. Beispielsweise ist das Vielschichtbauelement 1 ein Piezoaktor oder ein Vielschichtkondensator. Das Vielschichtbauelement weist einen Grundkörper 2 mit darauf angeordneten Außenkontaktierungen 3a, 3b auf. Der Grundkörper ist beispielsweise ein Stapel aus piezoelektrischen Schichten 23 und dazwischen angeordneten internen Elektrodenschichten 20a, 20b.

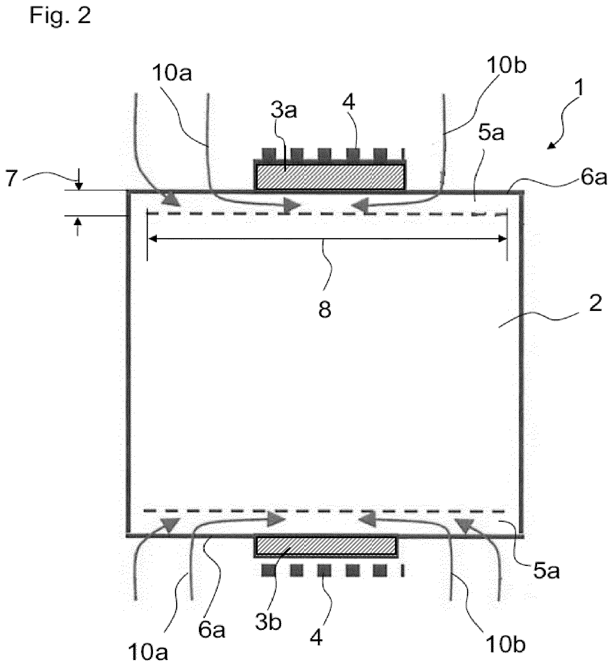

Zudem weist der Grundkörper erste und zweite Kavitäten 5a, 5b, insbesondere erste und zweite Gräben auf. Insbesondere sind die Kavitäten 5a, 5b an zwei gegenüberliegenden Außenseiten 6a, 6b angeordnet. Die Kavitäten 5a, 5b sind beispielsweise durch ein Ätzverfahren hergestellt. Beispielsweise weisen die Kavitäten 5a, 5b eine Breite 22 zwischen 1 $\mu$m und 5 $\mu$m, eine Tiefe 7 zwischen 80 $\mu$m und 120 $\mu$m und eine Länge 8 zwischen 2 mm und 10 mm auf(siehe auch Figur 2).

Die ersten und zweiten Kavitäten 5a, 5b sind beispielsweise in einer Ebene mit ersten und zweiten internen Elektrodenschichten 20a, 20b des Grundkörpers 2 angeordnet. Insbesondere sind die Kavitäten 5a, 5b jeweils zwischen einer Außenseite 6a, 6b des Grundkörpers 2 und ersten und zweiten internen Elektrodenschichten 20a, 20b angeordnet. Durch die Kavitäten sind die internen Elektrodenschichten von einer Außenseite 6a, 6b beabstandet. Die ersten Kavitäten 5a sind zu einer ersten Außenseite 6a offen, und die zweiten Kavitäten 5b sind zu einer zweiten Außenseite 6b offen. Eine auf den Außenseiten 6a, 6b angeordnete Außenkontaktierung 3a, 3b überdeckt die Kavitäten 5a, 5b nur teilweise, wie beispielsweise in Figur 2 gezeigt. Insbesondere sind die Kavitäten 5a, 5b von der jeweiligen Außenseite 6a, 6b aus zugänglich und können, wie nachfolgend beschrieben, mit einem Füllmaterial, insbesondere einem Isoliermaterial gefüllt werden.

Ein geeignetes Isoliermaterial ist beispielsweise ein Silikon-Elastomer mit einer Viskosität von 400 mPas.

Durch eine mit Füllmaterial gefüllten zweiten Kavität 5b können die ersten internen Elektrodenschichten 20a von einer zweiten Außenkontaktierung 3b zuverlässig isoliert werden. Auf diese Weise kann ein elektrischer Durchschlag zwischen der Außenkontaktierung 3b und einer internen Elektrodenschicht 20a vermieden werden. Auf die gleiche Weise kann eine zweite interne Elektrodenschicht 20b von einer ersten Außenkontaktierung 3a isoliert sein.

Zudem oder alternativ können die Kavitäten 5a, 5b als Sollbruchbereiche wirken. Beispielsweise kann eine mit Füllmaterial gefüllte Kavität 5a, 5b einen Bereich reduzierter Bruchfestigkeit bilden, der beim Anlegen einer Spannung an das Vielschichtbauelement 1 einreißen kann.

Die Außenkontaktierungen 3a, 3b sind auf jeweils gegenüberliegenden Außenseiten 6a, 6b des Grundkörpers 2 angeordnet. Die Außenkontaktierungen 3a, 3b weisen beispielsweise ein metallhaltiges Material auf. Beispielsweise weisen die Außenkontaktierungen 3a, 3b Silber-Palladium oder Kupfer oder Silber auf, oder bestehen aus Silber-Palladium oder Kupfer oder Silber. Die Außenkontaktierungen 3a, 3b sind beispielsweise mittels Siebdruck aufgebracht und anschließend eingebrannt. Beispielsweise sind die Außenkontaktierungen 3a, 3b streifenförmig ausgebildet. Insbesondere sind die Außenkontaktierungen 3a, 3b an den Außenseiten 6a, 6b angeordnet, an welchen die Kavitäten 5a, 5b angeordnet sind. Die Außenkontaktierungen 3a, 3b überdecken die Kavitäten 5a, 5b zumindest teilweise. An den Außenkontaktierungen 3a, 3b ist jeweils ein Kontaktelement 4 angeordnet. Das Kontaktelement 4 ist beispielsweise mit der Außenkontaktierung 3 verlötet. Das Kontaktelement 4 kann beispielsweise einen Kontaktdraht aufweisen. Zusätzlich kann das Kontaktelement 4 ein Verstärkungselement aufweisen, beispielsweise ein Siebgewebe oder eine Drahtharfe.

Die Kavitäten 5a, 5b werden wie nachfolgend beschrieben mit Füllmaterial gefüllt.

Figur 2 zeigt eine Schnittdarstellung des Vielschichtbauelements 1 aus Figur 1 in einer Draufsicht. Hier ist ersichtlich, dass die Außenkontaktierungen 3a, 3b über den Kavitäten 5a, 5b angeordnet sind, so dass sie einen Teil der Kavitäten 5a, 5b abdecken. Insbesondere sind die Außenkontaktierungen 3a, 3b streifenförmig ausgebildet, und erstrecken sich nicht über die gesamte Breite des Vielschichtbauelements 1. Da sich die Kavitäten 5a, 5b jedoch nahezu vollständig über die gesamte Breite des Vielschichtbauelements 1 erstrecken, sind die Kavitäten 5a, 5b immer noch über eine Außenseite 6a, 6b zugänglich. Insbesondere können die Kavitäten 5a, 5b über die Außenseiten 6a, 6b mit Füllmaterial befüllt werden.

Auf den Außenkontaktierungen 3a, 3b ist jeweils ein Kontaktelement 4 mit einem Siebgeflecht angeordnet.

In Figur 2 ist der Materialstrom des Füllmaterials durch Pfeile 10a, 10b angedeutet.

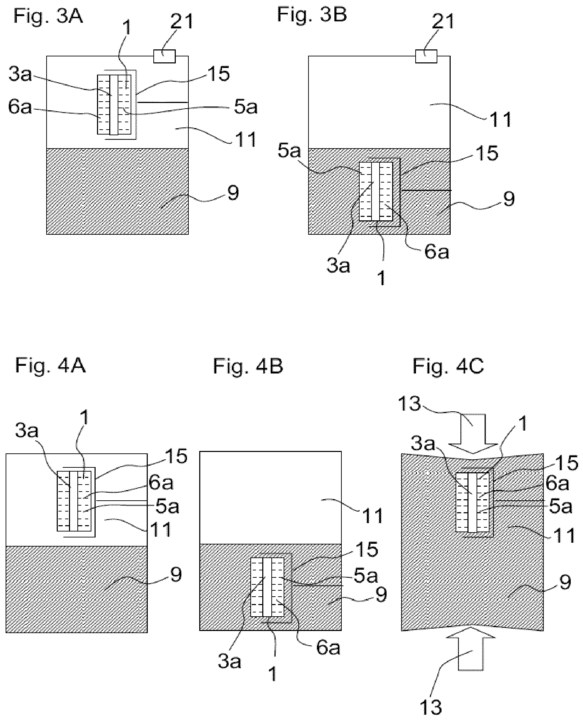

Die Figuren 3A und 3B zeigen schematisch einen Verfahrensablauf zum Befüllen der Kavitäten 5a, 5b eines Vielschichtbauelements wie in einer der Figuren 1 und 2 dargestellt mit Füllmaterial 9. Das Füllmaterial weist beispielsweise eine Viskosität zwischen 200 mPas und 2000 mPas auf. Beispielsweise weist das Füllmaterial eine Viskosität zwischen 300 mPas und 500 mPas auf. Ein Füllmaterial 9 mit einer derartigen Viskosität fließt nicht selbstständig in die Kavitäten 5a, 5b mit den wie oben beschriebenen Abmessungen. Ein solches Füllmaterial 9 kann beispielsweise mit einem Lösungsmittel verdünnt werden, so dass es eine geringere Viskosität aufweist. Die Verwendung solcher Lösungsmittel kann infolge des Abtrocknens des Lösungsmittels beim Aushärten jedoch Blasenbildung im Füllmaterial 9 verursachen. Anhand des erfindungsgemäßen Verfahrens kann das Füllmaterial 9 wie im Folgenden beschrieben in die Kavitäten gefüllt werden, ohne dass die Verwendung eines Lösungsmittels notwendig ist.

Zunächst wird das Vielschichtbauelement 1 zum Befüllen der Kavitäten mit Füllmaterial 9 in einer Kammer 11 platziert. Die Kavitäten 5a, welche sich bis zu einer Außenseite 6a erstrecken, sind der Einfachheit halber in den Figuren 3A und 3B als gestrichelte Linien dargestellt. Auf einer gegenüberliegenden Außenseite 6b, welche in den folgenden Figuren nicht sichtbar ist, sind entsprechend Kavitäten 5b vorhanden. Beispielsweise ist das Vielschichtbauelement 1 wie in Figur 1 ausgebildet.

In der Kammer 11 befindet sich ein Füllmaterial 9. Das Vielschichtbauelement 1 wird zunächst in der Kammer 11 platziert, ohne dass es mit dem Füllmaterial 9 in Berührung kommt, wie in Figur 3A dargestellt. Beispielsweise wird das Vielschichtbauelement 1 in einer Einspannvorrichtung 15 eingespannt.

Nach dem Platzieren des Vielschichtbauelements 1 in der Kammer 11 wird beispielsweise ein erster Druck, insbesondere ein Unterdruck erzeugt. Beispielsweise kann ein Vakuum erzeugt werden. Beispielsweise liegt der erste Druck zwischen 0 mbar und 300 mbar. Vorzugsweise liegt der erste Druck zwischen 5 mbar und 20 mbar. Der Druck kann insbesondere auf den Dampfdruck des Füllmaterials 9 abgestimmt sein. Dadurch kann verhindert werden, dass das Füllmaterial 9 verdampft. Durch das Erzeugen des Unterdrucks in der Kammer 11 kann beispielsweise Luft aus den Kavitäten 5a, 5b entfernt werden, um ein späteres Entstehen von Bläschen in dem Füllmaterial 9 zu vermeiden.

Wie in Figur 3B dargestellt wird nach dem Anlegen des ersten Drucks das Vielschichtbauelement 1 in das Füllmaterial 9 eingetaucht, so dass die freiliegenden Stellen der Kavitäten 5a, 5b vollständig mit Füllmaterial bedeckt sind. Anschließend wird in der Kammer 11 der Druck auf einen zweiten Druck erhöht. Zu diesem Zweck ist in der Kammer 11, beispielsweise in einem Deckel der Kammer 11, ein Ventil 21 angeordnet. Insbesondere wird das Füllmaterial 9 unter Druck gesetzt. Dies geschieht, indem beispielsweise die Kammer 11 belüftet wird oder erfindungsgemäß ein Überdruck erzeugt wird. Beispielsweise wird der Druck in der Kammer 11 um 300 mbar bis 2000 mbar gegenüber dem ersten Druck erhöht. Vorzugsweise wird der Druck in der Kammer 11 um 900 mbar bis 1100 mbar erhöht. Bekannterweise entspricht der zweite Druck dem normalen Luftdruck. Durch das Erhöhen des Drucks kann das Füllmaterial 9 in die Kavitäten 5a, 5b des Vielschichtbauelements 1 fließen. Insbesondere wird das Füllmaterial 9 in die Kavitäten 5a, 5b gedrückt. Insbesondere wird das Füllmaterial 9 auch in die Bereiche der Kavitäten 5a, 5b gedrückt, welche durch eine Außenkontaktierung 3a, 3b verdeckt sind. Der Fluss des Füllmaterials in die Kavitäten ist in Figur 2 durch Pfeile 10a, 10b dargestellt. Insbesondere kann ein Füllmaterial 9 mit einer relativ hohen Viskosität in die Kavitäten 5a, 5b fließen, ohne dass die Verwendung eines verdünnenden Mittels notwendig ist. Dadurch können Hohlräume im Füllmaterial vermieden werden, welche beim Aushärten eines lösungsmittelhaltigen Füllmaterials entstehen können. Der Fluss des Füllmaterials in die Kavitäten ist in den Figuren durch Pfeile 10 dargestellt.

Anschließend wird das Vielschichtbauelement aus der Kammer 11 entfernt. Nach einem Aushärten des Füllmaterials 9, beispielsweise durch Temperatureinbringung, kann das Vielschichtbauelement 1 weiter verarbeitet werden.

Die Figuren 4A, 4B und 4C zeigen schematisch einen alternativen Verfahrensablauf zum Befüllen der Kavitäten 5a, 5b eines Vielschichtbauelements 1 wie in einer der Figuren 1 oder 2 dargestellt mit Füllmaterial 9. Zunächst wird das Vielschichtbauelement in einem Schritt 4A wie bereits in Zusammenhang mit Figur 3A beschrieben in einer Kammer 11 positioniert. Die Kammer 11 ist teilweise mit einem Füllmaterial 9 angefüllt. Anschließend wird, wie vorhergehend beschrieben, ein erster Druck, insbesondere ein Unterdruck in der Kammer 11 erzeugt.

In einem nachfolgenden 4B Schritt kann der Grundkörper 2 entsprechend Figur 3B in Füllmaterial getaucht werden, so dass die Kavitäten 5a, 5b des Grundkörpers mit Füllmaterial 9 bedeckt sind. Anschließend wird die Kammer 11 belüftet und, wie in Figur 4C gezeigt, weiter mit Füllmaterial 9 befüllt, bis die Kammer 11 vorzugsweise vollständig ausgefüllt ist. Daraufhin wird die Kammer 11 verschlossen. Anschließend wird die Kammer 11 durch Krafteintragung verformt, beispielsweise durch eine Presse. Die Krafteintragung ist in Figur 4C durch Pfeile 13 dargestellt. Durch die Verformung der Kammer 11 wird der Druck auf das Füllmaterial 9 erhöht. Dadurch wird Füllmaterial 9 analog zu dem in 3B beschriebenen Verfahrensschritt in die Kavitäten 5a, 5b gedrückt. Da durch eine Presse ein großer Druck im Füllmaterial 9 aufgebaut werden kann, eignet sich dieses Verfahren besonders für hochviskose Füllmaterialien.

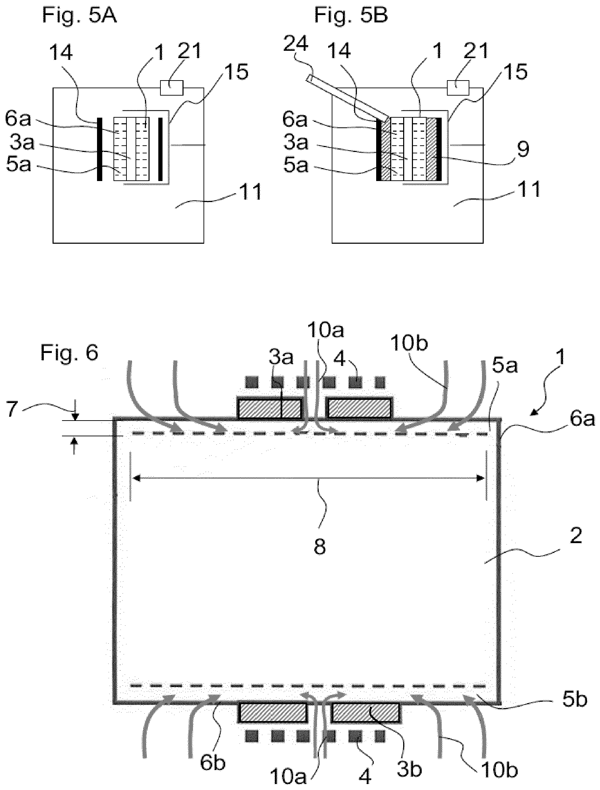

Die Figuren 5A und 5B zeigen schematisch einen weiteren alternativen Verfahrensablauf zum Befüllen der Kavitäten 5 eines Vielschichtbauelements wie in einer der Figuren 1 oder 2 dargestellt mit Füllmaterial 9.Das Vielschichtbauelement 1 wird zunächst in einer Hülse 14 platziert. Anschließend wird das Vielschichtbauelement mit der Hülse 14 in einer Kammer 11 positioniert. Dazu kann die Hülse 14 in eine Einspannvorrichtung 15 eingespannt werden. Danach wird in der Kammer 11 ein erster Druck, insbesondere ein Unterdruck erzeugt.

In einem darauffolgenden Schritt wird, wie in Figur 5B dargestellt, die Hülse 14 mit Füllmaterial 9 gefüllt, zum Beispiel mittels einer Sonde 24. Anschließend wird die Kammer 11 beispielsweise über ein Ventil 21 belüftet oder ein zweiter Druck, insbesondere ein Überdruck erzeugt. Dadurch wird das Füllmaterial 9 in die Kavitäten 5a, 5b des Vielschichtbauelements 1 gedrückt. Durch die Hülse 14 ist das Vielschichtbauelement 1 beispielsweise vor Schmutz oder mechanischen Einflüssen geschützt. Insbesondere erlaubt die Hülse 14 einen sparsamen Einsatz von Füllmaterial, da die Kammer 11 nicht mit Füllmaterial gefüllt sein muss. Zudem kann das Füllmaterial 9 in der Hülse 14 verbleiben und nach dem Aushärten als Passivierungsmaterial dienen.

Die in Zusammenhang mit den Figuren 3A bis 5B beschriebenen Verfahren haben den Vorteil, dass Kavitäten eines Vielschichtbauelements mit Füllmaterial befüllt werden können, welches eine relativ hohe Viskosität aufweist, ohne dass die Zugabe eines verdünnenden Lösungsmittels notwendig ist. Dadurch kann Blasenbildung im Füllmaterial verringert werden.

Figur 6 zeigt eine Schnittdarstellung eines weiteren Vielschichtbauelements 1. Das Vielschichtbauelement 1 ist ähnlich wie das Vielschichtbauelement gemäß den Figuren 1 und 2 ausgebildet, abgesehen von der Form der Außenkontaktierung 3. Die Außenkontaktierung 3a des in Figur 6 gezeigten Vielschichtbauelements 2 weist einen Spalt 16 entlang der Stapelrichtung des Grundkörpers 2 auf. Der Spalt 16 weist beispielsweise eine Breite zwischen 300 $\mu$m und 800 $\mu$m auf. Die Breite des Spaltes 16 entspricht einer Ausdehnung des Spaltes 16 senkrecht zur Stapelrichtung des Grundkörpers 2. Aufgrund des Spalts 16 kann die Weiterkontaktierung 4 beispielsweise einen in der Außenkon-tierung 3a auftretenden Riss überbrücken. Zudem kann eine bessere Umspülung der Außenkontaktierung 3a möglich sein, da das Füllmaterial eine kürzere Strecke in dem schwer zugänglichen Bereich unter der Außenkontaktierung 3a zurücklegen muss.

Der mögliche Materialstrom des Füllmaterials ist durch Pfeile 10a, 10b angedeutet. Insbesondere kann das Füllmaterial über einen Bereich auf der Außenseite 6a, der neben der Außenkontaktierung 3a liegt, und über einen Bereich auf der Außenseite 6a, der unter dem Spalt 16 liegt, in die Kavitäten 5a gedrückt werden, wie in Zusammenhang mit Figuren 3A bis 5B beschrieben, und kann so in den Bereich unterhalb der Außenkontaktierung 3a gelangen.

Auf einer gegenüberliegenden Außenseite 6b kann das Füllmaterial analog in die Kavitäten 5b gedrückt werden.

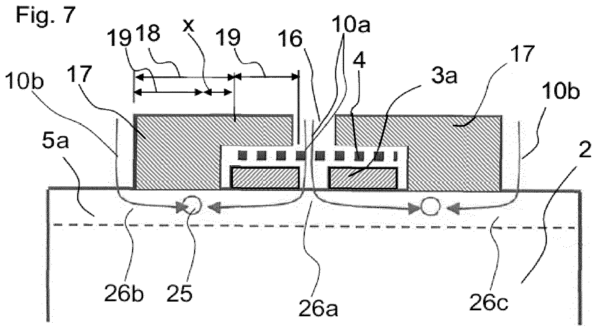

Figur 7 zeigt das Vielschichtbauelement aus Figur 6 mit zwei zusätzlich über der Außenkontaktierung 3a angeordneten Blenden 17. Die Blenden 17 sind symmetrisch über der Außenkontaktierung 3a angeordnet. Durch die Blenden 17 wird der Spalt 16 der Außenkontaktierung 3a nicht abgedeckt. Eine Blende 17 kann ein Bestandteil der Einspannvorrichtung 15 oder ein separates Bauteil sein. Eine Blende 17 ist derart über der Außenkontaktierung 3a angeordnet, dass sie zusammen mit der Außenkontaktierung einen durchgehenden Bereich der Außenseite 6a des Grundkörpers und insbesondere eine Kavität 5a abdeckt. In dem abgedeckten Bereich sind die Kavitäten 5a nicht über die Außenseite 6a zugänglich. Vorzugsweise deckt eine Blende 17 einen Bereich auf der Außenseite 6a des Grundkörpers 2 ab, der neben der Außenkontaktierung 3a liegt, und dessen Breite 18 größer ist als die Breite 19 des durch die Außenkontaktierung 3a durchgängig abgedeckten Bereichs Insbesondere ist die Breite 18 um ein Maß x breiter als die Breite 19 der Außenkontaktierung. In dem von einer Blende 17 und der Außenkontaktierung 3a abgedeckten Bereich auf der Außenseite 6a des Grundkörpers 2 kann kein Füllmaterial direkt in die Kavitäten 5a einströmen. Der Bereich der Außenkontaktierung 3a, in welchem der Spalt 16 angeordnet ist, bleibt von einer Blende 17 frei. Insbesondere kann während dem Befüllen der Kavitäten 5a mit Füllmaterial das Füllmaterial durch den Spalt 16 einströmen.

Das Einströmen des Füllmaterials in die Kavitäten 5a erfolgt durch den Spalt 16 und durch einen Bereich auf der Außenseite 6a des Grundkörpers 2, welcher nicht von einer Blende 17 oder der Außenkontaktierung 3a überdeckt ist. Das Einströmen des Füllmaterials erfolgt beispielsweise symmetrisch. Insbesondere erfolgt der Materialfluss in die Kavitäten 5a durch den Spalt 16 mit der gleichen Geschwindigkeit und der gleichen Durchflussmenge wie durch einen anderen Bereich der Außenseite 6a des Grundkörpers 2, welcher an einem dem Spalt 16 abgewandten Ende einer Blende 17 angrenzt. Insbesondere erfolgt der Materialfluss durch drei Eintrittsöffnungen 26a, 26b, 26c. Die Eintrittsöffnungen 26a, 26b, 26c sind beispielsweise an den Enden der durch die Blenden 17 und durch die Außenkontaktierung 3a abgedeckten Bereiche angeordnet. Insbesondere treffen Ströme 10a, 10b des Füllmaterials, welche durch die Eintrittsöffnungen 26a, 26b, 26c einströmen, in den Kavitäten 5a unterhalb der Blenden 17 aufeinander. Aufgrund des symmetrischen Einströmens des Füllmaterials treffen die Ströme 10a, 10b in der Mitte zwischen den Eintrittsöffnungen 26a und 26b, und in der Mitte zwischen den Eintrittsöffnungen 26a und 26c aufeinander. Insbesondere treffen die Ströme 10a, 10b des Füllmaterials in der jeweiligen Mitte der Blenden 17 aufeinander. Da die Blenden derart angeordnet sind, dass ihre jeweilige Mitte nicht oberhalb der Außenkontaktierung 3a liegt, treffen die Ströme 10a, 10b in einem Bereich aufeinander, der nicht unterhalb der Außenkontaktierung 3a liegt.

Es können im Füllmaterial Blasen 25 entstehen. Die Blasen 25 entstehen bevorzugt in einem Bereich, in welchem die Materialströme 10a, 10b des Füllmaterials aufeinander treffen. Durch das Verlagern dieses Zusammentreffens in einen Bereich, welcher nicht unterhalb der Außenkontaktierung 3a liegt, kann das Risiko verringert werden, dass Blasen 20 im Bereich der Außenkontaktierung 3a entstehen.

Das in Figur 7 gezeigte Ausführungsbeispiel kann in abgewandelter Form auch eine Außenkontaktierung ohne Spalt und eine entsprechend asymmetrisch über der Außenkontaktierung angeordneten Blende aufweisen. Entscheidend ist, dass der Bereich, in dem sich die Materialströme des Füllmaterials treffen, nicht in einem Bereich unterhalb der Außenkontaktierung liegt.

Bezugszeichen

| | |
|---|---|
| 1 | Vielschichtbauelement |
| 2 | Grundkörper |
| 3a | erste Außenkontaktierung |
| 3b | zweite Außenkontaktierung |
| 4 | Kontaktelement |
| 5a | erste Kavität |
| 5b | zweite Kavität |
| 6a | erste Außenseite |
| 6b | zweite Außenseite |
| 7 | Tiefe |
| 8 | Länge |
| 9 | Füllmaterial |
| 10a, 10b | Materialströme |
| 11 | Kammer |
| 13 | Pfeile |
| 14 | Hülse |
| 15 | Einspannvorrichtung |
| 16 | Spalt |
| 17 | Blende |
| 18 | Breite |
| 19 | Breite |
| 20a | erste interne Elektrodenschicht |
| 20b | zweite interne Elektrodenschicht |
| 21 | Ventil |
| 22 | Breite |
| 23 | piezoelektrische Schichten |
| 24 | Sonde |
| 25 | Blasen |
| 26a, 26b, 26c | Eintrittsöffnung |
| x | Übermaß |

**Patentansprüche**

**1.** Verfahren zum Befüllen von mindestens einer Kavität (5a, 5b) eines Vielschichtbauelements (1) für einen Piezoaktor oder für einen Vielschichtkondensator mit Füllmaterial (9), umfassend die Schritte:

A) Bereitstellen eines Grundkörpers (2) des Vielschichtbauelements (1), wobei der Grundkörper (2) mindestens eine Kavität (5a, 5b) aufweist,
B) Platzieren des Grundkörpers (2) in einer Kammer(11),
C) Erzeugen eines ersten Drucks, wobei der erste Druck ein Unterdruck ist,
D) Anordnen des Füllmaterials (9) an dem Grundkörper (2),

wobei das Verfahren ferner den Schritt
Erhöhen des Drucks in der Kammer (11) auf einen zweiten Druck nach dem Anordnen des Grundkörpers (2) in dem Füllmaterial (9) umfasst,
**dadurch gekennzeichnet, dass** der zweite Druck ein Überdruck ist.

2. Verfahren nach Anspruch 1, wobei die Erhöhung des Drucks durch Belüften der Kammer (11) erfolgt.

3. Verfahren nach einem der Ansprüche 1 oder 2, wobei durch das Erhöhen des Drucks Füllmaterial (9) in die mindestens eine Kavität (5a, 5b) gedrückt wird.

4. Verfahren nach einem der vorhergehenden Ansprüche, wobei das Füllmaterial (9) eine Viskosität zwischen 200 mPas und 2000 mPas aufweist.

5. Verfahren nach einem der vorhergehenden Ansprüche, umfassend den Schritt:

Aushärten des Füllmaterials (9).

6. Verfahren nach einem der vorhergehenden Ansprüche, wobei die mindestens eine Kavität (5a, 5b) durch ein Ätzverfahren hergestellt ist.

7. Verfahren nach einem der vorhergehenden Ansprüche, wobei die mindestens eine Kavität (5a, 5b) eine Breite zwischen 1 $\mu$m und 5 $\mu$m aufweist.

8. Verfahren nach einem der vorhergehenden Ansprüche, wobei der Grundkörper (2) mindestens eine interne Elektrodenschichten (20a, 20b) aufweist, und wobei die mindestens eine Kavität (5a, 5b) in einer Ebene mit der mindestens einen internen Elektrodenschicht (20a, 20b) angeordnet ist.

9. Verfahren nach einem der vorhergehenden Ansprüche, wobei der Grundkörper (2) mindestens eine Außenkontaktierung (3a, 3b) aufweist, welche auf einer Außenseite (6a, 6b) des Grundkörpers angeordnet ist und welche die mindestens eine Kavität (5a, 5b) zumindest teilweise überdeckt.

10. Verfahren nach einem der vorhergehenden Ansprüche, wobei eine Blende (17) zumindest teilweise über der mindestens einen Kavität (5a, 5b) angeordnet wird.

11. Verfahren nach Anspruch 10, wobei die Blende (17) zusammen mit der Außenkontaktierung (3a, 3b) einen durchgehenden Bereich auf der Außenseite (6a, 6b) des Grundkörpers (2) abdeckt, und wobei die Blende (17) in einem Bereich, der neben der Außenkontaktierung (3a, 3b) liegt, eine Breite (18) aufweist, welche größer als die Breite (19) eines durch die Außenkontaktierung durchgängig abgedeckten Bereichs der Außenseite (6a, 6b).

## Claims

1. Method for filling at least one cavity (5a, 5b) of a multi-layer component (1) for a piezoelectric actuator or for a multi-layer capacitor with filling material (9), comprising the following steps:

A) providing a main body (2) of the multi-layer component (1), the main body (2) having at least one cavity (5a, 5b),
B) placing the main body (2) in a chamber (11),
C) generating a first pressure, the first pressure being a negative pressure,
D) arranging the filling material (9) on the main body (2),

wherein the method further comprises the following step
increasing the pressure in the chamber (11) to a second pressure after the main body (2) has been arranged in the filling material (9), **characterized in that** the second pressure is an excess pressure.

2. Method according to Claim 1, wherein the pressure is increased by aerating the chamber (11).

3. Method according to either of Claims 1 and 2, wherein filling material (9) is pressed into the at least one cavity (5a, 5b) by the increase in the pressure.

4. Method according to one of the preceding claims, wherein the filling material (9) has a viscosity of between 200 mPas and 2000 mPas.

5. Method according to one of the preceding claims, comprising the following step:

    curing the filling material (9).

6. Method according to one of the preceding claims, wherein the at least one cavity (5a, 5b) is produced by an etching method.

7. Method according to one of the preceding claims, wherein the at least one cavity (5a, 5b) has a width of between 1 $\mu$m and 5 $\mu$m.

8. Method according to one of the preceding claims, wherein the main body (2) has at least one internal electrode layer (20a, 20b), and wherein the at least one cavity (5a, 5b) is arranged in a plane with the at least one internal electrode layer (20a, 20b).

9. Method according to one of the preceding claims, wherein the main body (2) has at least one outer contact-making means (3a, 3b), which is arranged on an outer side (6a, 6b) of the main body and which at least partially covers the at least one cavity (5a, 5b).

10. Method according to one of the preceding claims, wherein a diaphragm (17) is arranged at least partially over the at least one cavity (5a, 5b).

11. Method according to Claim 10, wherein the diaphragm (17) together with the outer contact-making means (3a, 3b) covers a continuous region on the outer side (6a, 6b) of the main body (2), and wherein, in a region which lies next to the outer contact-making means (3a, 3b), the diaphragm (17) has a width (18) which is greater than the width (19) of a region of the outer side (6a, 6b) covered continuously by the outer contact-making means.


**Revendications**

1. Procédé destiné à remplir avec une matière de charge (9) au moins une cavité (5a, 5b) d'un composant (1) multicouches pour un actionneur piézoélectrique ou pour un condensateur multicouches
comprenant les étapes :

    A) de la mise à disposition d'un corps de base (2) du composant multicouches (1), le corps de base (2) comportant au moins une cavité (5a, 5b),
    B) du placement du corps de base (2) dans une chambre (11),
    C) de la génération d'une première pression, la première pression étant une dépression,
    D) de la disposition de la matière de charge (9) sur le corps de base (2),

    le procédé comprenant par ailleurs l'étape de l'augmentation de la pression dans la chambre (11) à une deuxième pression après la disposition du corps de base (2) dans la matière de charge (9),
    **caractérisé en ce que** la deuxième pression est une surpression.

2. Procédé selon la revendication 1, l'augmentation de la pression s'effectuant par aération de- la chambre (11).

3. Procédé selon l'une quelconque des revendications 1 ou 2, par l'augmentation de la pression, de la matière de charge (9) étant poussée dans l'au moins une cavité (5a, 5b).

4. Procédé selon l'une quelconque des revendications précédentes, la matière de charge (9) présentant une viscosité comprise entre 200 mPa et 2000 mPa.

5. Procédé selon l'une quelconque des revendications précédentes, comprenant l'étape :

   du durcissement de la matière de charge (9).

6. Procédé selon l'une quelconque des revendications précédentes, l'au moins une cavité (5a, 5b) étant fabriquée par un procédé de gravure.

7. Procédé selon l'une quelconque des revendications précédentes, l'au moins une cavité (5a, 5b) présentant une largeur comprise entre 1 $\mu$m et 5 $\mu$m.

8. Procédé selon l'une quelconque des revendications précédentes, le corps de base (2) comportant au moins une couche interne d'électrodes (20a, 20b) et l'au moins une cavité (5a, 5b) étant disposée dans un plan avec l'au moins une couche interne d'électrodes (20a, 20b).

9. Procédé selon l'une quelconque des revendications précédentes, le corps de base (2) comportant au moins un contact extérieur (3a, 3b) lequel est disposé sur une face extérieure (6a, 6b) du corps de base et lequel recouvre au moins partiellement l'au moins une cavité (5a, 5b).

10. Procédé selon l'une quelconque des revendications précédentes, un cache (17) étant disposé au moins partiellement sur l'au moins une cavité (5a, 5b).

11. Procédé selon la revendication 10, en commun avec le contact externe (3a, 3b), le cache (17) recouvrant une zone continue sur la face extérieure (6a, 6b) du corps de base (2) et dans une zone qui se situe à côté du contact externe (3a, 3b), le cache (17) présentant une épaisseur (18) qui est supérieure à la largeur (19) d'une zone de la face extérieure (6a, 6b) recouverte en continu par le contact externe.

Fig. 1

Fig. 2

Fig. 3A

Fig. 3B

Fig. 4A

Fig. 4B

Fig. 4C

Fig. 5A

Fig. 5B

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006001656 A1
- DE 4410504 B4
- DE 102007004813 A1
- US 2003223155 A1
- JP 2005055489 A
- JP H0473977 A